(19) **Europäisches Patentamt**
**European Patent Office**
**Office européen des brevets**

(11) Publication number : **0 076 809**
**B2**

(12) **NEW EUROPEAN PATENT SPECIFICATION**

(45) Date of publication of the new patent specification :
24.01.90

(51) Int. Cl.⁵ : **G 01 R 21/00**, G 01 R 15/08

(21) Application number : 82901064.4

(22) Date of filing : 19.02.82

(86) International application number :
**PCT/US 82/00204**

(87) International publication number :
**WO/8202954 (02.09.82 Gazette 82/21)**

(54) MULTIPLE RATE ELECTRICAL ENERGY METERING APPARATUS.

(30) Priority : 26.02.81 US 238450

(43) Date of publication of application :
20.04.83 Bulletin 83/16

(45) Publication of the grant of the patent :
08.10.86 Bulletin 86/41

(45) Mention of the opposition decision :
24.01.90 Bulletin 90/04

(84) Designated contracting states :
CH DE FR GB LI

(56) References cited :
DE--A-- 2 446 602
DE--A-- 2 707 200
FR--A-- 2 406 827
GB--A-- 2 046 925
US--A-- 3 502 980
US--A-- 4 050 020
US--A-- 4 179 654
US--A-- 4 229 795
US--A-- 4 298 839
US--A-- 4 301 508

(73) Proprietor : GENERAL ELECTRIC COMPANY
1 River Road
Schenectady New York 12305 (US)

(72) Inventor : DI MASSIMO, Donald Vincent
7357 Westgate Lane
Liverpool, NY 13088 (US)
Inventor : MAY, John Bruce
3936 Willowbrook Lane
Liverpool, NY 13088 (US)
Inventor : JOHNSON, Brian Cory
116 Huntington Road
Syracuse, NY 13219 (US)
Inventor : COOPER, Jeffrey Lynn
701 First Street
Liverpool, NY 13088 (US)

(74) Representative : Sanders, Peter Colin Christopher
BROOKES & MARTIN High Holborn House 52/54 High Holborn
London WC1V 6SE (GB)

**Description**

This invention relates to the measurement of electrical energy consumption by power system customers, and more particularly to improved apparatus for metering electrical energy consumption at multiple rates depending upon the time of day, time of week and time of year during which the energy is being consumed.

Electrical energy is sold generally on the basis of a fixed rate schedule. Because of this fixed rate structure, electrical generation and distribution systems are overloaded at certain times, and at other times, are only lightly loaded. There is no incentive for customers to limit their peak load time use. This results in substantial inefficiencies since a much larger plant and distribution system than is economically desirable is required in order to meet peak demands of the generation and distribution system.

Prior attempts have been made to charge a lower rate for electrical energy consumption during off-peak periods and a higher rate for energy consumption during on-peak periods. This is to encourage the user to consume electrical energy during off-peak periods to level the load requirements placed on the power system.

One prior apparatus for metering the consumption of electrical energy at multiple rates is disclosed by Germer, et al in U.S. Patent 4 050 020. This apparatus employs three sets of decade gear driven dials for registering kilowatt hours consumed on a continuous basis, kilowatt hours consumed during preselected mid-peak intervals, and kilowatt hours consumed during preselected high-peak intervals. A programmable control circuit controls the operation of the alternate sets of decade gear driven dials at predetermined times.

Additionally, systems have been developed for measuring maximum peak power consumption over a predetermined time period. This is referred to as « demand » metering. To permit power companies to have generating capability to supply all consumers at all times, it is necessary that peak loads be predictable. Thus, there is a practice of metering and billing users based on peak load demand within a given period of time, typically 15 minutes during system peak-load times of day. This gives the user an incentive to maintain a level load and not exceed a predetermined peak.

In a demand metering system, the consumption of power is measured and recorded on a demand meter register during demand intervals of a predetermined length. Previously, the demand interval length had been for a fixed length of time (e. g. 15 or 30 minutes). However, for greater flexibility in demand metering, the utility companies required a universal meter which could be readily altered to change the demand interval length without making extensive mechanical or electrical modifications. One such meter is disclosed in U.S. Patent No. 4 179 654 Germer.

Another weakness in demand metering, whether for a fixed length demand interval or for a demand interval length which can be changed, has been that there is customarily a complete reset and restart of the demand interval measurement at fixed times such as every 15 minutes or every half hour. This has led to inaccuracies in demand measurements if a peak demand load is in operation through the end of one demand metering interval and the beginning of a succeeding demand interval so as to distribute and dilute the peak demand over two demand intervals. It has been proposed to provide for a so called « sliding » demand measurement interval in order to overcome this difficulty by matching the demand measurement interval with the actual time interval of maximum load demand. One such system is disclosed in U.S. Patent No. 4 229 795, Vieweg et al. However, that system includes a serious limitation in that the duration of the demand measurement interval is fixed, and therefore, inflexible, in spite of the « sliding » demand period feature.

Another problem encountered in prior systems has been that they typically require hardware for providing a visual readout of all of the various measurements which are being made by the metering system on a continuous and concurrent basis.

A programmable multi-rate metering system is disclosed in GB-A-2 046 925. In this system pulses representative of the electrical energy consumed by the load are accumulated in different registers during different preselected time of use periods, while a further register accumulates the total number of pulses received. A visual display is also provided which sequentially and repeatedly displays the contents of selected registers in the system. The system particularly includes a number of registers for maximum demand metering during the different time of use periods.

In a system disclosed in DE-OS-2 707 200 for signalling an impending mains failure to a maximum demand meter, a predetermined number of mains cycles may be counted when re-establishing power after a power failure. This is to ensure that the mains is re-established and running smoothly before the maximum demand register resumes its calculations.

A problem which arises with both the above systems, and in fact with all demand metering systems, is that immediately after a power outage a customer will often require an exceptionally high level of power for a short interval of time. Accordingly, if the restoration of power occurs during a time when maximum demand is being metered, the customer will be penalised for using this high level of power even though he has just been deprived of power through no fault of his own.

According to the present invention this problem is solved by detecting a power outage and providing means responsive to the output of the detection means for delaying the measurement of the maximum demand rate for a predetermined time period after restoration of power such that a maximum rate of demand for power immediately following a power outage is not measured by the respective register even though power is restored during one of the periods when maximum demand is being metered.

By way of example only, in the accompanying drawings :

Fig. 1 is a schematic block diagram of a preferred apparatus for carrying out the present invention ;

Fig. 2 is a more detailed schematic block diagram depicting the central processing unit, the input data selector, the output data selector, and the associated interconnecting portions of the apparatus of Fig. 1.

Fig. 3 is a more detailed schematic block diagram depicting the display processor/controller and display portions of the apparatus of Fig. 1:

Fig. 4 is a schematic diagram depicting a communication link interface circuit referred to in Fig. 1.

Fig. 5 i. e. Figs. 5A and 5B considered as a unit is a schematic diagram representation of data storage registers and associated logical apparatus for the collection and accumulation of electrical energy measurements which are incorporated in the central processing unit microprocessor 12 and in the memory unit 14 of Fig. 1.

Fig. 6 is a schematic detail illustrating a time delay feature in the reapplication of power to a controlled load after a power down condition.

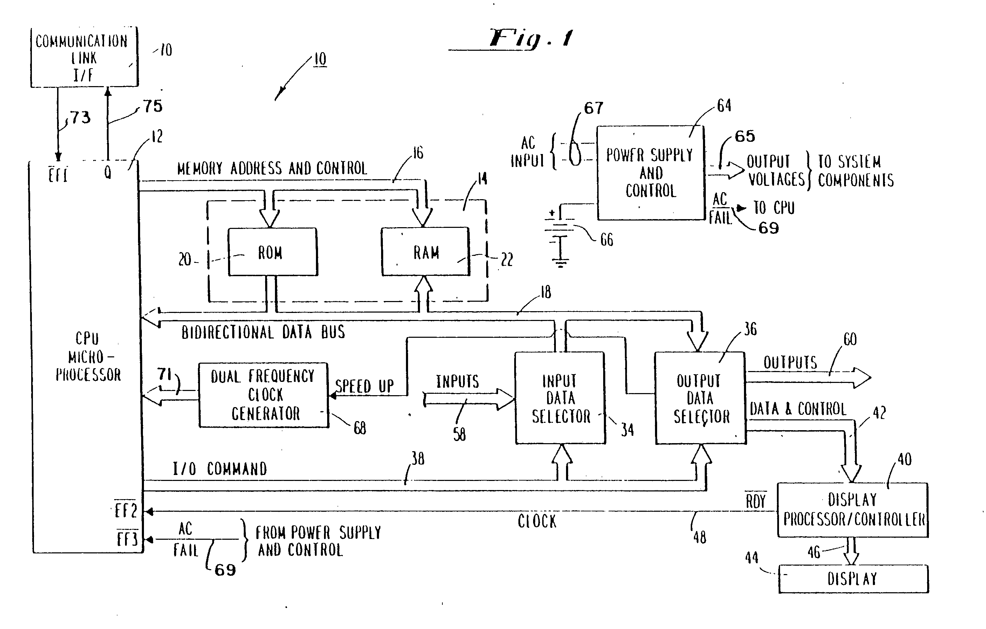

Referring to Fig. 1 of the drawing, there is shown a schematic block diagram of the preferred embodiment of the apparatus of the present invention, generally designated 10. The apparatus 10 includes a central processing unit comprising a microprocessor 12. In the preferred embodiment, the microprocessor 12 is an RCA CDP 1802 COS-MAC Microprocessor. The microprocessor 12 is electrically connected to an external memory 14 by means of a ·memory address and control circuit 16 and bidirectional data bus 18.

In the preferred embodiment, the external memory 14 comprises a read only memory (ROM) 20 and a random access memory (RAM) 22. The ROM 20 is preferably a Supertex, Incorporated Model MM3200 Read Only Memory organized in a 4096 × 8 configuration. The RAM 22 preferably comprises a pair of Harris Corporation model HM-6513-L 512 × 4 RAM's (24 and 26) interconnected to provide a 512 × 8 memory array.

The apparatus 10 additionally includes an input data selector 34 and an output data selector 36 which are electrically connected to the microprocessor 12 by means of the bi-directional data bus 18 and an input/output command section 38. The output data selector 36 is electrically connected to a display processor/controller 40 by means of a data and control bus 42. The display processor/controller 40 is electrically connected to a display 44 by means of a display control bus 46. In addition, the display processor/controller 40 is electrically connected to the microprocessor 12 by means of a clock line 48.

The apparatus also includes a power supply and control circuit 64 which supplies the appropriate voltages, as indicated at 65, to the various components of the multiple rate metering apparatus 10. The power supply and control circuit 64 derives its primary source of power from the monitored power distribution system, as indicated at 67. However, there is also provided a carryover battery 66 for supplying carryover power to the apparatus 10 in the event of a power outage in the monitored distribution system. The power supply and control circuit 64 includes AC fail battery switchover, battery test, and interrupt generating circuits which monitor the primary and secondary (carryover) power sources and provide for continued operation, in a reduced keep-alive mode which keeps trace of passing time during primary power outage. The failure of primary power is signalled from the power circuit 64 to the microprocessor 12 on a connection 69.

Also shown in Fig. 1 is a block representation of a dual frequency clock generator 68 connected at 71 to provide the clock frequency necessary to operate the microprocessor 12. The dual frequency clock generator 68 is capable of supplying a clock signal having a higher frequency, approximately 1 MHz during normal operation, and a lower frequency 1 KHz, during primary power outages.

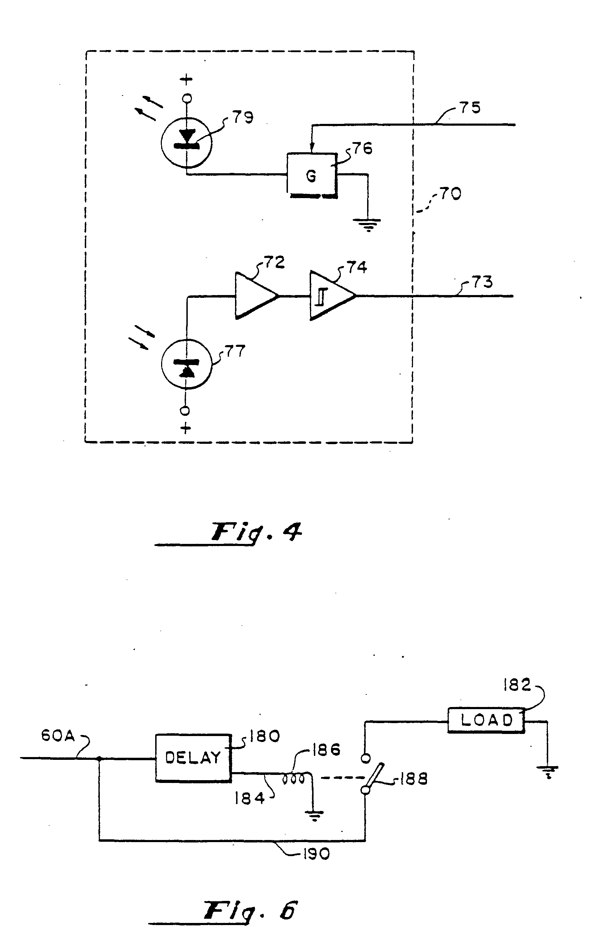

In Fig. 1, there is also shown a communication link interface circuit 70 which is electrically connected a 73 to the input/output flag input 1 (EF1) and at 75 to the Q output (Q) terminal of the microprocessor 12. The communication link 70 is described further below in connection with Fig. 4.

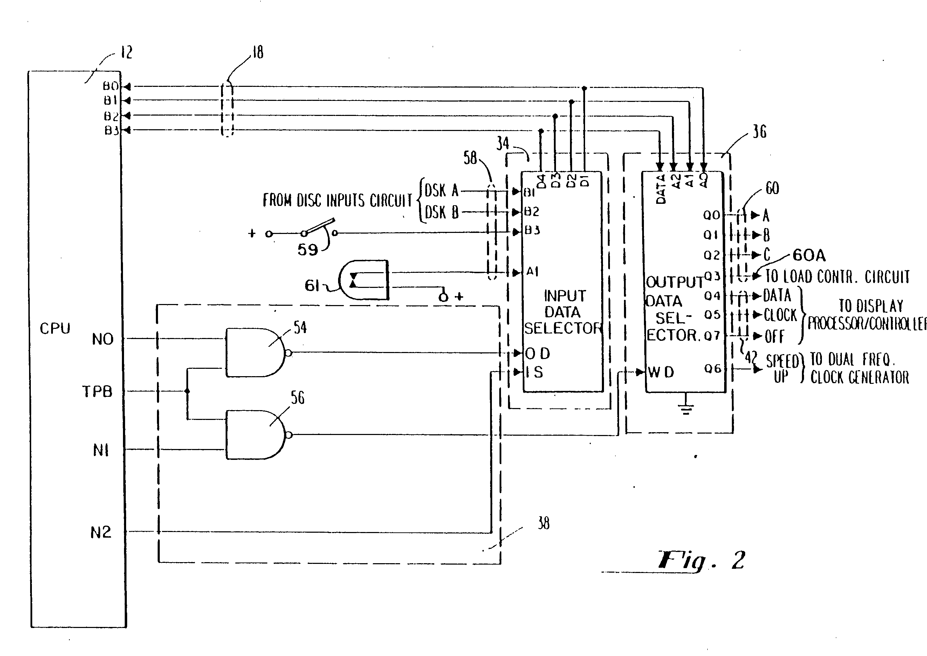

Referring now to Fig. 2, there is shown a schematic block diagram depicting the interconnection of the microprocessor 12, the input data selector 34, the output data selector 36 and the input/output command section 38. The input data selector 34 preferably may be implemented by an RCA type CD40257B COS/MOS Quad 2-Line-to-1-Line Data Selector/Multiplexer. The output data selector 36 preferably may be implemented by an RCA type CD4099B COS/MOS 8-bit Addressable Latch. The input/output command section 38 comprises a first two input NAND gate 54 and a second two input NAND gate 56.

Inputs 58 are electrically connected to the data selector 34 as shown in Fig. 2, with the input from disc circuit A (DSK A) connected to terminal B1 ; the input from disc circuit B (DSK B) connected to terminal B2 ; the input from a demand reset switch 59 connected to terminal B3 and the input from a display activate switch 61 connected to input terminal A1. In the preferred embodiment, the inputs DSK A and DSK B, are developed from the rotating disc of a watt-hour meter. Optical electronics convert the disc rotation information, as developed by sensing slot locations, to electrical pulse signals over the two lines to terminals B1 and B2 of the input data selector 34. These signals are indicative of the amount of electrical energy being consumed in the measured system. Such a structure is shown and described in U.S. Patent No. 4 179 654-Germer. The demand reset switch 59 is preferably a manually activated momentary switch as illustrated schematically in the drawing. Display active switch 61 is preferably a magnetically activated switch, such as a reed switch, which may be activated by a magnetic wand.

The outputs D1 through D4 of the data selector 34 are electrically connected to data input/output ports B0 through B3 respectively of the microprocessor 12 by means of the bi-directional data bus 18.

Outputs 60 from the output data selector 36 comprise alert signals A, B and C and a load control signal at 60A from output terminal Q0, Q1, Q2 and Q3 respectively. The output terminals Q0, Q1 and Q2 are electrically connected to external alert circuits while the output terminal Q3 is electrically connected at 60A to a load control circuit. The output connections 42 from terminals Q4, Q5 and Q7, generating DATA, CLOCK, and OFF signals respectively, are electrically connected to the display processor/controller 40. The input/output data terminals, B0 through B3, of the microprocessor 12 are electrically connected to the address input terminals A0 through A2, and the data input terminal respectively of the output data selector 36 by means of the bi-directional data bus 18.

The input/output command output 0 (N0) terminal of the microprocessor 12, is electrically connected to one input of a first two input NAND gate 54. The timing pulse B (TPB) output terminal of the microprocessor 12 is electrically connected to the other input of the first two input NAND gate 54 and one input of a second two input NAND gate 56. The input/output command output 1 (N1) terminal of the microprocessor 12 is electrically connected to the other input of the second two input NAND gate 56. The output of the first NAND gate 54 is electrically connected to the output disable terminal OD of the data selector 34. The output of the second NAND gate 56 is electrically connected to the write disable terminal WD of the output data selector 36.

The input/output command output 2 (N2) terminal of the microprocessor 12 is electrically connected to the input select terminal IS of the data selector 34. By generating the appropriate command and control signals at its terminals N0, TPB and N2, as will be subsequently described, the microprocessor can cause data representative of the selected input 58 to appear at the data output terminals D1 through D4 of the data selector 34. Similarly, by generating the appropriate signals at its output terminals TPB and N1, as will be subsequently described, the microprocessor 12, can cause output data from its input/output data terminal B3 to appear at a selected one of the output terminals Q0 through Q7 of the output data selector 36 as determined by the signals appearing on the input/output data terminals B0 through B2 of the microprocessor 12.

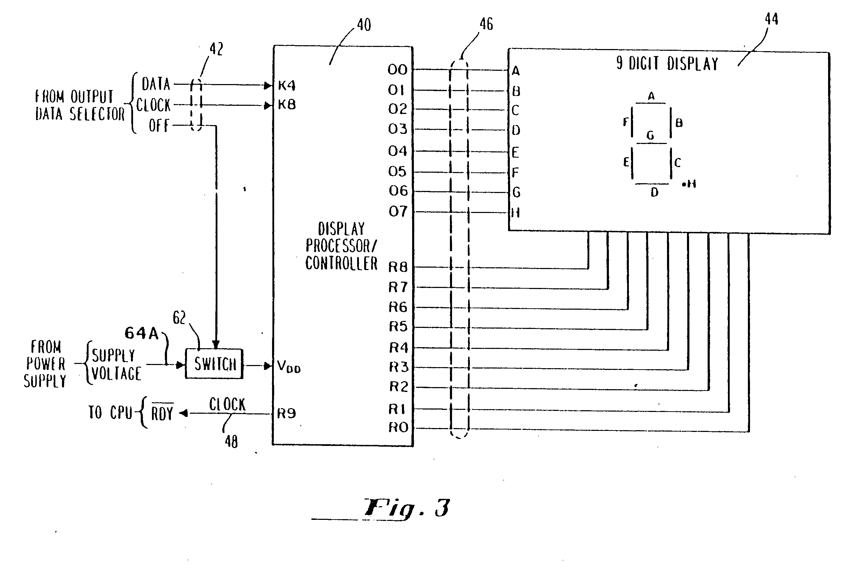

Referring now to Fig. 3, there is shown a schematic block diagram depicting the interconnection of the display process/controller 40 and the display 44 by means of the display control bus 46. In the preferred embodiment, the display processor/controller 40 may be a Texas Instruments TMS1070 microcomputer. The display 44 is preferably a Futaba model No. 9-ST-68 9-Digit Vacuum Fluorescent Display. « O » outputs 00 through 07 of the display processor/controller 40 are electrically connected to the segment control inputs A through H respectively of the display 44 by means of the display control bus 46. The « R » outputs R0 through R8 of the processor/controller 40 are electrically connected to the digit control inputs R0 through R8 respectively of the display 44 by means of the display control bus 46. The data and clock outputs from the output data selector 36 are electrically connected through bus 42 to the K4 and K8 inputs respectively of the processor/controller 40. The OFF output from the output data selector 36 controls an electronic switch 62 which selectively controls the appropriate supply voltage through connection 64A from a power supply and control circuit 64 (Fig. 1) to the supply voltage terminal $V_{DD}$ of the display processor/controller 40. The R9 terminal of the processor/controller is electrically connected to the input/output flag input 2 (EF2) terminal of the microprocessor 12 via the clock line 48.

Fig. 4 is a schematic detail of the communication link 70. Communication link 70 includes a photo detector 77 and a light emitting diode 79. The signal from the photo detector 77 is connected to the input of an amplifier comparator 72, the output of which is connected to the input of a Schmitt trigger 74. The output of the Schmitt trigger 74 is electrically connected at 73 to the EF1 terminal of the microprocessor 12. In the preferred embodiment, the comparator 72 is an RCA type CA 139G Quad Comparator. The Schmitt trigger 74 is preferably an RCA type CD 40106 B « COS/MOS Hex Schmitt trigger ». The Q output from the microprocessor 12 is electrically connected at 75 to an electronic switch 76 which controls the application of power to the light emitting diode (LED) 79.

The operation of the communication link interface circuit 70 is as follows. An optical communication link (not shown) having a light transmitter (for example an LED) and a light detector (for example a photo transistor), is positioned next to, and optically coupled with the communication link interface circuit 70 in a complementary relationship with the LED 79 and photo detector 77 of the interface circuit 70. In the preferred embodiment, the LED 79 and photo detector 77 of the interface circuit 70 are mounted side by side in an optical port of the multiple rate metering apparatus 10. This coupling permits the LED of the optical link to align with the photo detector 77 of the interface circuit 70 while the photo detector of the optical link is positioned opposite the LED 79 of the interface circuit 70. Upon the detection of light emitted from the LED of the optical link, the photo detector 77 generates a signal which is input to the Schmitt trigger 74 through the comparator 72. The Schmitt trigger 74 generates a pulse which is coupled through connection 73 to the EF1 terminal of the microprocessor 12. In addition, a signal generated by the microprocessor 12 at its Q output terminal through connection 75 will cause the electronic switch 76 to complete a power circuit to the LED 79 causing the LED to emit light. This emitted light is detected by the photo detector of the optical link which in turn generates a signal for use at the other end of the optical link.

In a preferred embodiment, the apparatus 10 of Fig. 1 is programmable and reprogrammable to meet changing rate designs utilizing the through-the-cover optical communication link 70, preferably using a portable programmer/tester (not shown). This same link can be implemented for automated reading and recording of meter data if desired. The preferred embodiment of the apparatus 10 is programmable for 5 years, regardless of how many of the programmable functions are used. It can accommodate up to 10 holidays per year and 4 seasonal rate changes per year. The time of use schedule can be different for each season with up to 8 daily set points on quarter hour intervals. In addition, the apparatus can accommodate a week-end/holiday schedule for each season with up to 6 daily set points on quarter hour intervals. Daylight savings time changes and leap year are also accommodated.

Thirty-three registers selectively displayable on the 9 digit vacuum fluorescent display 44, which display can be programmed to sequence through the quantities selected for display at preselected times. The display is also capable of being activated by the magnetic wand which when placed in proximity to the magnetic display activate switch (61, Fig. 2) previously described, activates the switch. The wand can be used to fast forward the display until the selected register is located, or to single step the display to the next register, if desired. In addition, holding the magnetic wand at the meter for greater than a preselected time period (one second in the preferred embodiment) can initialize the display to the first register. As shown in Fig. 2, disc inputs are available to the input data selector 34 at terminals B1 and B2. As previously stated, these inputs are developed from the rotating disc of the kilowatt hour meter. Other inputs to the input data selector 34 include reset demand (at B3) and display activate at A1.

The output data selector 36 is used to couple information from the microprocessor 12 to three alert outputs A, B and C at 60. Each alert output is active when the time of use period associated with that particular alert is in existence ; and, as each rotation of the disc occurs, that particular alert output will be a pulse signal. In the preferred embodiment, optical couplers/isolators develop an electrically isolated output pulse for each rotation of the disc. In addition, a load control output 60A from the output data selector 36 activates a relay, the contacts of which can be used to selectively control an external load. Other outputs 42 from the data selector 36 are used to transmit data and control signals to the display processor/controller 40. Another output at Q6 controls the output frequency of the dual frequency clock generator 68 (Fig. 1). Clock generator 68 provides a high frequency clock signal (approximately 1 $MH_2$) to the microprocessor 12 during normal operations, and a low frequency clock signal (1 $KH_2$) during AC power outage conditions.

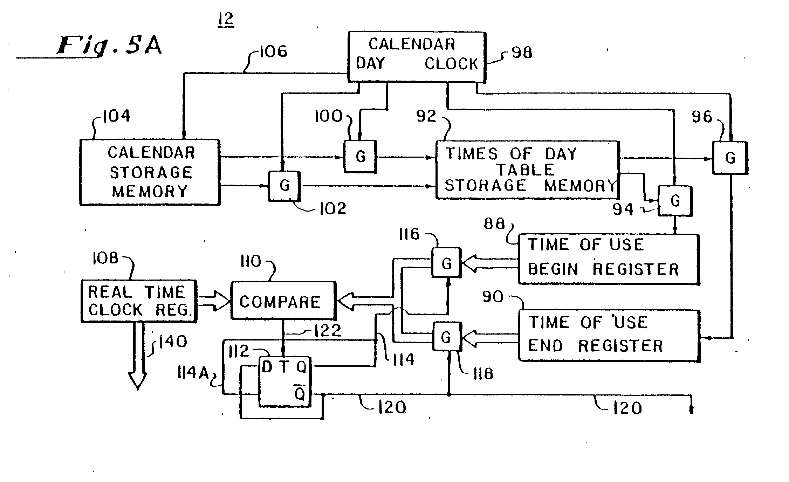

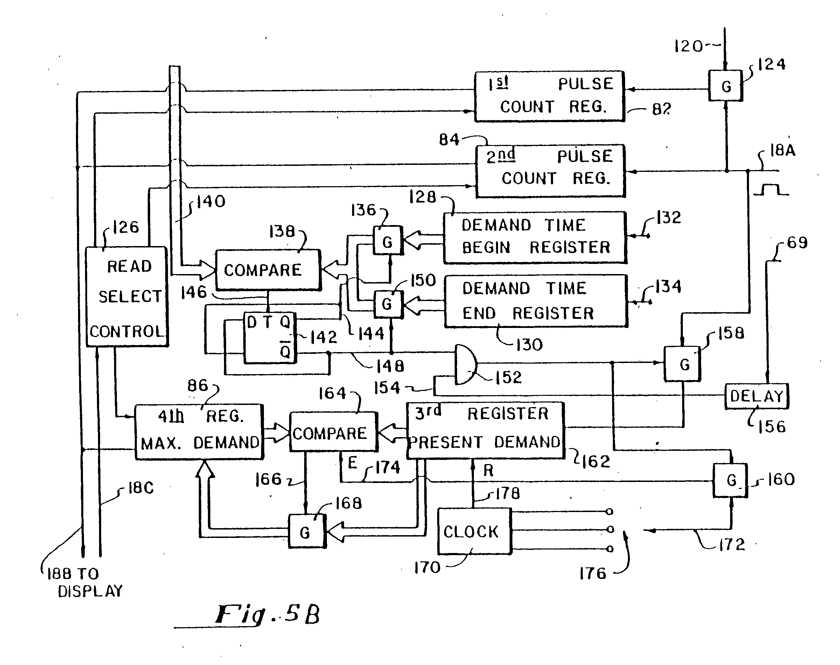

Fig. 5 is a schematic circuit diagram illustrating registers which are employed for storing electrical energy measurements in accordance with the present invention and which are included in the central processing unit microprocessor 12 of Fig. 1, or in the associated memory address and control unit 14, together with associated switching logic and memory and register circuits for controlling the delivery of data to the data registers in accordance with the present invention.

The data storage registers illustrated in Fig. 5 include a first pulse count register 82 for storing and accumulating a total count of pulses received during a preselected time of use during each day as a measure of electrical energy consumption during that period. A second register 84 is arranged to accumulate the total count of pulses received as a measure of total energy consumed, and a fourth register 86 is provided for accumulating a maximum count of pulses received during a limited period as a measurement of the maximum demand for electrical energy consumed during that limited period.

The time of use period during which pulses are accumulated in the first pulse count register 82 is determined by a number representative of the beginning of a time of use during a particular day stored in a register 88, and a number stored in a register 90 indicative of the end of the time of use. The numbers stored in registers 88 and 90 are gated from a times of day table storage memory 92 by means of gating devices 94 and 96 under the control of a calendar day clock 98. Particular times of day are selected from the table storage memory 92 for days of particular classes, such as weekdays, holidays, Saturdays, and Sundays, by control signals gated through gates 100 and 102 from a calendar storage memory 104. Gates 100 and 102 are also controlled by clock 98.

The calendar storage memory 104 preferably stores the calendar for a number of years ahead, including recognition of a different status for the days of each season, each weekend day, and each holiday. The calendar day clock 98 issues a series of new control signals each day, operating through a connection 106 to the calendar storage memory 104 to advance the recognition of a new date from the calendar storage memory 104. The control signals supplied from the calendar day clock 98 to the gates 100 and 102 then cause a gating through of day type information to the times of day table storage memory 92 to appropriately select the proper times of day for the beginning and the end of the time of use period for which energy is to be recorded in register 82. Those times of day are then gated by the calendar day clock signals from 98 through gates 94 and 96 to the time of use begin register 88 and the time of use end register 90. The detection of the actual occurrence of the time of use to begin is then determined by comparing the real time, as shown by a real time clock register 108 with the time of use begin time stored in register 88 by means of a compare circuit 110. A bistable control circuit 112 is normally initially in the set state so as to operate through a connection 114 to enable a gate 116 connecting the begin register 88 to the compare circuit 110 for comparison with the real time clock register 108. Under these conditions, a corresponding gate 118 from the end register 90 to the compare circuit 110 is not enabled because that gate relies upon an enablement signal from the reset output at connection 120 from the bistable circuit 112.

However, as soon as the compare circuit 110 indicates an identity between the contents of the begin register 88 and the real time clock register 108, the compare circuit 110 issues a signal on a connection 122 to a trigger input of the bistable circuit 112. Since there is a cross connection, indicated at 114A from the set output 114 to the reset input of the bistable circuit 112, the trigger input is effective to change the state of the bistable circuit 112, disabling the gate 116, and enabling the gate 118. The reset output on connection 120 also is effective to enable a gate 124 which gates input pulses from a pulse input connection 18A to the first pulse count register 82 to commence or recommence the accumulation of pulses indicative of electrical energy consumed. The connection 18A represents a part of the data available from the data bus 18 of Fig. 1 from the input data selector 34, and represents pulses derived from one of the meter disc input pulse sources, indicative of energy consumed.

With the gate 118 enabled, the compare circuit 110 will be effective to detect a comparison between the real time indicated by the clock register 108 and the end time stored in the end register 90. The circuit thus recognizes the end of the time of use to issue another output signal on connection 122 to the trigger input of the bistable circuit 112 to again change its state to the set state. This disables gates 118 and 124, and stops the accumulation of pulse counts in the first pulse count register 82.

The second pulse count register 84 is connected directly to the pulse input connection 18A to receive and count all of the pulses which are available, to thus accumulate all of the pulses as a measure of the total electrical energy consumed. The contents of either of the registers 82 or 84 may be selected for display by means of a read select control 126 which is operable in response to a signal received over the bus 18, as schematically indicated at 18C. The selective readout control signals supplied from the read select control circuit 126 to the registers 82 and 84 cause the contents of one of those registers to be read out upon a common display information bus indicated at 18B. Again, the function of the display bus 18B may be carried out by the data bus 18 of Fig. 1.

The invention also preferably includes demand measurement circuitry, including circuitry for determining a time of day during which demand is to be measured. This may be accomplished in a manner similar to that for determining the time of use in connection with registers 88 and 90. Registers corresponding to registers 88 and 90 are shown at 128 and 130 for respectively storing the beginning of the demand time in register 128 and the end of the demand time in register 130. These registers may be set to different time values for different days for the times of day table storage memory 92 through connections 132 and 134, which are not shown in full.

Before the demand time begins, the contents of the demand time begin register 128 are gated through the gating device 136 to a compare circuit 138 for comparison with the real time from the real time clock register 108 through connection 140. The gate 136 is controlled by a bistable circuit 142 through the set output connection 144. As soon as an identity is recognized, indicating that the demand begin time has arrived, the compare circuit 138 issues an output signal on the connection 146 to the trigger input of the bistable circuit 142, causing that bistable circuit to reset, disabling gate 136. The reset output from bistable circuit 142 at connection 148 enables a gate 150 so that the compare circuit 138 is ready to detect the end of the demand time interval.

The signal on connection 148 also enables an AND gate 152. The other input 154 of the AND gate 152 is normally enabled through a delay circuit 156 by a signal from connection 69. The enablement of AND gate 152 provides enabling signals to gates 158 and 160. The gate 158 is connected from the pulse input connection 18A to a third register 162 for the purpose of accumulating pulses as a measure of present demand. The accumulation of pulses by the third register 162 is only for a limited demand interval.

At the end of each limited demand interval, the contents of the third register 162 are compared with the contents of the previously measured maximum demand for a similar interval stored in register 86 by means of a compare circuit 164. Compare circuit 164 is enabled for this purpose by a signal on connection 174. If the comparison indicates that the contents of the present demand register 162 exceed the contents of the maximum demand register 86, then the compare circuit 164 issues a control signal at the connection 166 to a gate 168 which is effective to transfer the pulse count stored in the present demand register 162 to the maximum demand register 86, as a new maximum value. The comparison operation at the end of the present demand interval is initiated by a clock signal from a clock 170 supplied through a connection 172 and gate 160 on connection 174 to the enable input of compare circuit 164. The length of the demand interval is preferably programmable, as schematically indicated at 176 by selecting different clock interval outputs to be supplied on connection 172.

The present demand register 162 is reset through a connection 178, from the clock 170. Reset typically occurs at the end of each present demand interval, and immediately after the initiation of the compare operation through connection 174. However, in accordance with a preferred embodiment of the invention, the reset of the present demand register 162 is only a partial reset, and the relationship between the frequency of the compare enable signal provided at connection 174, and the demand reset signals provided to the present demand register 162 through connection 178 is such as to provide for successively overlapping present demand time intervals, previously referred to above as a « sliding » demand measurement. Each partial reset of the present demand register 162 may simply consist of removing a single count from the register. Thus, register 162 may be of the kind which can be counted up or counted down, the signals provided through gate 158 being effective to count the register up, and the reset signals provided through connection 178 being effective to count the register down.

The maximum demand register 86 is also connected to the read select control circuit 126 for enablement by that control to provide a readout on the display bus 18B. Thus, the maximum demand measurement stored in register 86 is one of the alternative measurements which may be displayed. Whenever there is a reestablishment of power to a power customer, after a prior interruption of power, it is known that there may be a high demand for power for an initial interval. If this restoration of power occurs during a time when maximum demand is being measured, it is not desired to make an immediate demand measurement because it is not fair to the customer to have deprived him of power, and then penalize him because he requires additional catch up power to energize his previously neglected loads. Accordingly, the delay circuit 156 is provided which is effective to reenable AND gate 152 through connection 154 only after a predetermined delay interval after power is reinstated, as detected by an input on connection 69, which is a power failure signal, as previously described in connection with Fig. 1.

All of the clocks illustrated in Fig. 5 including the calendar day clock 98, the real time clock register 108, and the clock 170 which controls the demand metering function may be combined in a single clock structure, and are, in any case, controlled by the clock generator 68 of Fig. 1.

While specific special purpose circuitry is illustrated in Fig. 5 for accomplishing the measurement of the various energy values, it will be understood that these functions may be carried out by the general multi-purpose logic of the microprocessor 12 of Fig. 1 under the control of programs which are preferably stored in the read only memory section 20 of the memory unit 14 of Fig. 1.

While only three readable energy measurement storage registers 82, 84 and 86 are illustrated in Fig. 5, it will be understood that a number of other such registers may be provided for the storage of other energy quantities which may be alternatively read out by the read select control 126 to the single display device, as previously explained above.

Fig. 6 schematically illustrates another preferred feature of the invention wherein a system load 182 is reconnected only after a preselected time interval following the reconnection of power after a power outage in the monitored system. For accomplishing this purpose, the load control circuit referred to in relation to connection 60A of the connections 60 in Fig. 2 may be carried out as schematically illustrated in Fig. 6. The circuit is shown to include a time delay control circuit 180 which provides a time delay function for the reestablishment of power to the load schematically illustrated at 182. The initial reapplication of power at connection 60 begins the time delay interval. As soon as the time delay interval of circuit 180 expires, a signal appears at connection 184, energizing a winding 186 of a relay, picking up and closing the normally open contact 188 of that relay, and connecting power through a connection 190 to the load 182.

All of the drawings are simplified schematics. It will be understood that additional buffers, shift registers and logic gates may be required for reliable operation.

## Claims

1. A multiple rate electrical metering system comprising
   input means (58, 34, 18, Fig. 1 ; 18A, Fig. 5) adapted to receive pulses which are representative of electrical energy consumption by a load being monitored,
   means (88, 90, 110, 108, Fig. 5) for detecting the beginning and the end of a first preselected time of use period,
   first register means (82) connected to the input means (at 124) for accumulating the total count of pulses received during the said preselected time of use period,
   second register means (84) connected to the input means for accumulating the total count of pulses received,
   third register means (162, Fig. 5) connected (at 158) to the input means (18A) for accumulating the count of pulses received in each of a succession of predetermined demand time intervals of equal duration during a second preselected time of use period to measure the maximum rate of demand for power during the second preselected time of use period,
   means (18, 36, 42, 40, 46, Fig. 1 ; 18B, 126, Fig. 5) interconnecting at least the first and second register means with display means (44) for selectively reading out the contents of the registers to display means (44),
and characterised by

means (64, 69, Fig. 1) for detecting a power outage, and

means (12, 69, 156, 152, Fig. 5) connected to the power outage detection means and operable to delay the measurement of the maximum demand rate for a predetermined time period after the reestablishment of power such that a maximum rate of demand for power immediately following a power outage is not measured by said third register means (162) even though power is restored during one of said predetermined demand time intervals.

2. A metering system according to claim 1 further characterised by

means (170, 178) for resetting the third register means at regular intervals related to the demand time intervals so that the third register means can again accumulate a count of pulses to signify a maximum rate of demand during a new demand time interval,

fourth register means (86) for storing the maximum number of pulses counted during any one of the demand intervals as a measure of maximum demand,

means (164) for comparing the total count of pulses stored in the third register means (162) at the end of each demand interval with the contents of the fourth register means (86), and

means (168) operable in response to the comparing means for increasing the count stored in the fourth register means when the comparison of the count shows that the count stored in the third register means (162) exceeds the count stored in the fourth register means (86).

3. A metering system as claimed in claim 2 further characterised in that the means (170, 178, Fig. 5) for resetting said third register means (162) is operable to only partially reset the third register means (162) on each reset operation, the time span between successive endings of demand time intervals being less than a demand time interval so that the count of pulses stored in the third register means (162) at the end of each demand interval represents a count accumulated during a demand interval which overlaps with prior demand intervals.

4. A metering system as claimed in claim 3 further characterised by programmable means (176, Fig. 5) operable to selectively change the length of each demand time interval.

5. A metering system as claimed in any one of the claims 2, 3 or 4 further characterised by manually operable means (61, Fig. 2) for selectively activating the readout means (18, 36, 42, 40, 46, Fig. 1 ; 18B, 126, Fig. 5) to selectively display the contents of the first (82), second (84), or fourth (86) register means.

6. A metering system according to any one of the preceding claims further characterised by first storage means (104, Fig. 5) for storing preselected day types in chronological order by date of occurrence during a selected year, second storage means (92) for storing the times of day defining the time of use periods in chronological order by time of occurrence for each selected day type, clock means (108) for indicating real time, and comparison means (110) for periodically comparing the real time with the stored times to provide a signal (at 122) upon detection of a coincidence for controlling the accumulation of pulses in the first register means (82).

7. A metering system according to claim 6 in which the first storage means distinguishes between the days of different seasons in the calendar year.

8. A metering system according to any one of the preceding claims further characterised by means (180, 186, 188, Fig. 6) for reconnecting a load (182) only after a preselected time interval following the reconnection of power after a power outage.

9. A metering system according to any one of the preceding claims further characterised by an optical communication link interface (70, Fig. 1 ; 70, Fig. 4) for transmitting data and information to an external programmer-tester and for receiving data and information from the external programmer-tester.

## Patentansprüche

1. Mehrfachtarif-Elektrizitätszähler enthaltend

Eingangsmittel (58, 34, 18, Fig. 1 ; 18A, Fig. 5), die Impulse empfangen können, die den elektrischen Energieverbrauch durch eine überwachte Last darstellen,

Mittel (88, 90, 110, 108, Fig. 5) zum Abtasten des Anfangs und des Endes einer ersten vorgewählten Benutzungszeitperiode,

erste Registermittel (82), die mit den Eingangsmitteln verbunden sind (bei 124) zum Akkumulieren der Gesamtzahl an Impulsen, die während der vorgewählten Benutzungszeitperiode empfangen sind,

zweite Registermittel (84), die mit den Eingangsmitteln verbunden sind, zum Akkumulieren der Gesamtzahl empfangener Impulse,

dritte Registermittel (162, Fig. 5), die mit den Eingangsmitteln (18A) verbunden sind (bei 158), zum Akkumulieren der Anzahl von Impulsen, die in jeweils einer Folge vorbestimmter Bedarfszeitintervalle gleicher Dauer während einer zweiten vorgewählten Benutzungszeitperiode empfangen werden, um den maximalen Energiebedarf während der zweiten vorgewählten Benutzungszeitperiode zu messen,

Mittel (18, 36, 42, 40, 46, Fig. 1 ; 18B, 126 Fig. 5), die wenigstens die ersten und zweiten Registermittel mit einer Anzeigeeinrichtung (44) verbinden zum selektiven Auslesen des Inhalts der Register an die Anzeigeeinrichtung (44),

gekennzeichnet durch

Mittel (64, 69, Fig. 1) zum Abtasten eines Netzausfalls und

Mittel (12, 69, 156, 152, Fig. 5), die mit den Netzausfall-Abtastmitteln verbunden sind und betätigbar sind zum Verzögern der Messung des Maximalbedarfs für eine vorbestimmte Zeitperiode nach der Wiederherstellung des Netzes, so daß ein maximaler Energiebedarf unmittelbar nach einem Netzausfall durch die dritten Netzmittel (162) nicht gemessen wird, obwohl während eines der vorbestimmten Bedarfszeitintervalle das Netz wiederhergestellt ist.

2. Elektrizitätszähler nach Anspruch 1, gekennzeichnet durch Mittel (170, 178) zum Zurücksetzen der dritten Registermittel in regelmäßigen Intervallen, die in bezug zu den Bedarfszeitintervallen stehen, so daß die dritten Registermittel wieder eine Anzahl von Impulsen akkumulieren, um einen Maximalbedarf während eines neuen Bedarfszeitintervalles anzuzeigen,

vierte Registermittel (86) zum Speichern der maximalen Anzahl von Impulsen, die während eines der Bedarfsintervalle als ein Maß des maximalen Bedarfs gezählt sind,

Mittel (164) zum Vergleichen der Gesamtzahl von Impulsen, die in dem dritten Registermittel (162) am Ende jedes Bedarfsintervalls gespeichert sind, mit dem Inhalt der vierten Registermittel (86), und

Mittel (168), die auf die Vergleichsmittel ansprechen zum Vergrößern des in dem vierten Registermittel gespeicherten Zählwertes, wenn der Vergleich der Zählung zeigt, daß der in dem dritten Registermittel (162) gespeicherte Zählwert größer ist als der Zählwert, der in dem vierten Registermittel (86) gespeichert ist.

3. Elektrizitätszähler nach Anspruch 2, dadurch gekennzeichnet, daß die Mittel (170, 178, Fig. 5) zum Zurücksetzen des dritten Registermittels (162) das dritte Registermittel (162) bei jedem Rücksetzvorgang nur teilweise zurücksetzen, wobei die Zeitspanne zwischen aufeinanderfolgenden Endpunkten der Bedarfszeitintervalle kleiner ist als ein Bedarfszeitintervall, so daß der Zählwert von Impulsen, die in dem dritten Registermittel (162) am Ende jedes Bedarfsintervalls gespeichert sind, einen Zählwert darstellt, der während eines Bedarfsintervalls akkumuliert ist, das mit früheren Bedarfsintervallen überlappt.

4. Elektrizitätszähler nach Anspruch 3, dadurch gekennzeichnet, daß programmierbare Mittel (176, Fig. 5) betätigbar sind zum selektiven Verändern der Länge von jedem Bedarfszeitintervall.

5. Elektrizitätszähler nach einem der Ansprüche 2-4, gekennzeichnet durch manuell betätigbare Mittel (61, Fig. 2) zum selektiven Aktivieren der Auslesemittel (18, 36, 42, 40, 46, Fig. 1; 18B, 126, Fig. 5), um selektiv den Inhalt der ersten (82), zweiten (84) oder vierten (86) Registermittel anzuzeigen.

6. Elektrizitätszähler nach einem der vorstehenden Ansprüche, gekennzeichnet durch erste Speichermittel (104, Fig. 5) zum Speichern vorgewählter Tagestypen in chronologischer Reihenfolge durch Datum des Auftretens während eines gewählten Jahres, zweite Speichermittel (92) zum Speichern der Tageszeiten, die die Zeit von Benutzungsperioden in chronologischer Reihenfolge durch die Zeit des Auftretens für jeden gewählten Tagestyp definieren, Zeitmeßmittel (108) zum Anzeigen der Realzeit und Vergleichsmittel (110) zum periodischen Vergleichen der Realzeit mit den gespeicherten Zeiten, um bei Feststellung einer Koinzidenz ein Signal (bei 122) zu liefern zur Steuerung der Akkumulation von Impulsen in dem ersten Registermittel (82).

7. Elektrizitätszähler nach Anspruch 6, dadurch gekennzeichnet, daß das erste Speichermittel zwischen den Tagen in verschiedenen Jahreszeiten im Kalenderjahr unterscheidet.

8. Elektrizitätszähler nach einem der vorstehenden Ansprüche, gekennzeichnet durch Mittel (180, 186, 188, Fig. 6) zum Wiederanschluß einer Last (182) nur nach einem vorgewählten Zeitintervall nach der Wiederherstellung des Netzes nach einem Netzausfall.

9. Elektrizitätszähler nach einem der vorstehenden Ansprüche, gekennzeichnet durch ein optisches Kommunikationsverbindungsinterface (70, Fig. 1; 70, Fig. 4) zum Senden von Daten und Information an einen externen Programmtester und zum Empfangen von Daten und Information von dem externen Programmtester.

## Revendications

1. Un système de mesure d'énergie électrique à tarifs multiples comprenant :

des moyens d'entrée (58, 34, 18, figure 1 ; 18A, figure 5) conçus de façon à recevoir des impulsions qui sont représentatives de la consommation d'énergie électrique par une charge qui est contrôlée,

des moyens (88, 90, 110, 108, figure 5) destinés à détecter le début et la fin d'une première période d'utilisation présélectionnée,

un premier registre (82) connecté aux moyens d'entrée (en 124) pour accumuler le nombre total d'impulsions reçues pendant la période d'utilisation présélectionnée,

un second registre (84) connecté aux moyens d'entrée pour accumuler le nombre total d'impulsions reçues,

un troisième registre (162, figure 5) connecté (en 158) aux moyens d'entrée (18A) pour accumuler le nombre d'impulsions reçues dans chaque intervalle d'une succession d'intervalles de temps de consommation de crête prédéterminés de durée égale, pendant une seconde période d'utilisation présélectionnée, pour mesurer la consommation d'énergie de crête pendant la seconde période d'utilisation présélectionnée,

des moyens (18, 36, 42, 40, 46, figure 1 ; 18B, 126, figure 5) qui interconnectent au moins les premier et second registres avec des moyens de visualisation (44), pour transférer sélectivement le contenu des registres vers les moyens de visualisation (44),

et caractérisé par

des moyens (64, 69, figure 1) destinés à détecter une interruption d'énergie, et

des moyens (12, 69, 156, 152, figure 5) connectés aux moyens de détection d'interruption d'énergie et capables de retarder la mesure de la consommation de crête pendant une durée prédéterminée après le rétablissement de l'énergie de telle sorte que le troisième registre (162) ne mesure pas un taux maximum de consommation d'énergie immédiatement à la suite d'une interruption d'énergie même si l'énergie est rétablie pendant un desdits intervalles de temps de consommation prédéterminés.

2. Un système de mesure d'énergie selon la revendication 1, caractérisé en outre par :

des moyens (170, 178) destinés à restaurer le troisième registre à des intervalles réguliers liés aux intervalles de temps de mesure de la consommation de crête, de façon que le troisième registre puisse à nouveau accumuler un nombre d'impulsions pour déterminer une consommation de crête pendant un nouvel intervalle de temps de mesure de la consommation de crête,

un quatrième registre (86) destiné à enregistrer le nombre maximal d'impulsions comptées pendant l'un quelconque des intervalles de mesure de consommation de crête, à titre de mesure de la consommation de crête,

des moyens (164) destinés à comparer le nombre total d'impulsions enregistrées dans le troisième registre (162) à la fin de chaque intervalle de mesure de consommation de crête, avec le contenu du quatrième registre (86) et

des moyens (168) qui fonctionnent sous la dépendance des moyens de comparaisons de façon à augmenter le nombre enregistré dans le quatrième registre lorsque la comparaison du nombre montre que le nombre enregistré dans le troisième registre (162) est supérieur au nombre enregistré dans le quatrième registre (86).

3. Un système de mesure d'énergie selon la revendication 2, caractérisé en outre en ce que les moyens (170, 178, figure 5) destinés à restaurer le troisième registre (162) sont capables de ne restaurer que partiellement le troisième registre (162) à chaque opération de restauration, et la durée qui sépare des fins successives d'intervalles de temps de mesure de consommation de crête état inférieure à un intervalle de temps de mesure de consommation de crête, de façon que le nombre d'impulsions enregistré dans le troisième registre (162) à la fin de chaque intervalle de mesure de consommation de crête représente un nombre accumulé pendant un intervalle de mesure de consommation de crête qui est en chevauchement avec des intervalles de mesure de consommation de crête précédents.

4. Un système de mesure d'énergie selon la revendication 3, caractérisé en outre par des moyens programmables (176, figure 5) capables de changer sélectivement la longueur de chaque intervalle de temps de mesure de consommation de crête.

5. Un système de mesure d'énergie selon l'une quelconque des revendications 2, 3 ou 4, caractérisé en outre par des moyens (61, figure 2) pouvant être actionnés manuellement pour activer sélectivement les moyens de transfert (18, 38, 42, 40, 46, figure 1 ; 18B, 126, figure 5), pour visualiser sélectivement le contenu du premier registre (82), du second registre (84) ou du quatrième registre (86).

6. Un système de mesure d'énergie selon l'une quelconque des revendications précédentes, caractérisé en outre par des premiers moyens d'enregistrement (104, figure 5) destinés à enregistrer des types de jour présélectionnés, en ordre chronologique, par date d'apparition pendant une année sélectionnée, des seconds moyens d'enregistrement (92) destinés à enregistrer les heures de la journée qui définissent les périodes d'utilisation, en ordre chronologique, par instant d'apparition pour chaque type de jour sélectionné, des moyens d'horloge (108) destinés à indiquer l'heure réelle, et des moyens de comparaison (110) destinés à comparer périodiquement l'heure réelle avec les heures enregistrées pour produire un signal (en 122) sous l'effet de la détection d'une coïncidence, pour commander l'accumulation d'impulsions dans le premier registre (82).

7. Un système de mesure d'énergie selon la revendication 6, dans lequel les premiers moyens d'enregistrement font la distinction entre les jours de différentes saisons dans l'année calendaire.

8. Un système de mesure d'énergie selon la quelconque des revendications précédentes, caractérisé en outre par des moyens (180, 186, 188, figure 6) destinés à reconnecter une charge (182) seulement au bout d'un intervalle de temps présélectionné à la suite du rétablissement de l'énergie après une interruption d'énergie.

9. Un système de mesure d'énergie selon l'une quelconque des revendications précédentes, caractérisé en outre par une interface de liaison de transmission optique (70, figure 1 ; 70, figure 4) destinée à émettre des données et de l'information vers un programmateur-testeur externe, et à recevoir des données et de l'information à partir du programmateur-testeur externe.

Fig.1

Fig. 2

EP 0 076 809 B2

_Fig. 3_

_Fig. 4_

_Fig. 6_

Fig. 5A

CALENDAR DAY CLOCK ⌐98

CALENDAR STORAGE MEMORY ⌐104

TIMES OF DAY TABLE STORAGE MEMORY

TIME OF USE BEGIN REGISTER

TIME OF USE END REGISTER

REAL TIME CLOCK REG.

COMPARE

D T Q
Q̄

EP 0 076 809 B2

_Fig. 5B_

EP 0 076 809 B2